# EUROPÄISCHE PATENTSCHRIFT

(11) **EP 1 285 462 B1**
(45) Veröffentlichungstag und Bekanntmachung des Hinweises auf die Patenterteilung: **01.07.2015**
(21) Anmeldenummer: 01943054.5
(22) Anmeldetag: 10.05.2001
(51) Int. Cl.: H01L 23/057, H01L 23/13, H01L 23/498, H05K 1/02, H05K 3/34

(54) **HALBLEITERBAUELEMENT MIT OBERFLÄCHENMETALLISIERUNG**
SEMICONDUCTOR COMPONENT COMPRISING A SURFACE METALLIZATION
ELEMENT A SEMICONDUCTEUR AVEC METALLISATION DE SURFACE

(30) Priorität: 26.05.2000 DE 10025774
(43) Veröffentlichungstag der Anmeldung: 26.02.2003
(73) Patentinhaber: OSRAM Opto Semiconductors GmbH, 93055 Regensburg (DE)
(72) Erfinder: BRUNNER, Herbert, 93047 Regensburg (DE); HÖFER, Thomas, 93059 Lappersdorf (DE); JÄGER, Harald, 92536 Pfreimd (DE)
(74) Vertreter: Epping - Hermann - Fischer
(86) Internationale Anmeldenummer: PCT/DE2001/001785
(87) Internationale Veröffentlichungsnummer: WO 2001/091184

(56) Entgegenhaltungen:
- US-A- 4 682 270
- US-A- 5 081 520
- US-A- 5 198 886
- US-A- 5 929 516

## Beschreibung

Die Erfindung betrifft ein Halbleiterbauelement mit Oberflächenmetallisierung gemäß dem Oberbegriff des Patentanspruchs 1.

Halbleiterbauelemente mit Oberflächenmetallisierung sind beispielsweise bekannt aus US 5,081,520. Gezeigt ist hier ein Halbleiterbauelement mit einem Halbleiterkörper und einem Substrat, das auf seinen Hauptflächen Oberflächenmetallisierungen in Form von Leiterbahnstrukturen aufweist. Der Halbleiterkörper wird über einen Teilbereich der Leiterbahnstrukturen kontaktiert. Ein anderer Teilbereich der Leiterbahnstrukturen dient als Anschlußbereich des Bauelements.

Solche als Oberflächenmetallisierung ausgebildeten Anschlußflächen werden auch im Rahmen der sogenannten MID-Technik (Molded Interconnected Device) bzw. CIMID-Technik (Chip Integrated Molded Interconnected Device) verwendet, die z.B. aus US 5,929,516 bekannt ist.

Wie auch aus US 5,081,520 zu ersehen ist, werden die Anschlußflächen üblicherweise in der Nähe der Gehäuse- bzw. Substrataußenkanten ausgebildet. Ein bekanntes Anschlußschema besteht beispielsweise darin, die Anschlußflächen in zwei parallelen Reihen anzuordnen, die entlang zweier gegenüberliegender Außenkanten des Gehäuses verlaufen.

Nachteilig ist hierbei, daß bei Bauelementen der genannten Art im eingelöteten Zustand die Lötanschlüsse leicht abreißen, wenn das Bauelement einer Temperaturwechselbelastung ausgesetzt ist. Solche Temperaturwechselbelastungen können im normalen Betrieb, beispielsweise durch jahreszeitliche Änderung der Außentemperatur, bei Qualitätskontrollmaßnahmen wie Temperaturwechselprüfung und Temperaturschock oder beim Einlötprozeß selbst auftreten.

Aufgabe der vorliegenden Erfindung ist es, ein Halbleiterbauelement mit Oberflächenmetallisierung zu schaffen, dessen thermische Eigenschaften wie Temperaturbeständigkeit oder thermische Belastbarkeit verbessert sind. Weiterhin soll das Bauelement kostengünstig herstellbar sein.

Diese Aufgabe wird durch ein Halbleiterbauelement gemäß Anspruch 1 gelöst. Vorteilhafte Weiterbildungen der Erfindung sind Gegenstand der abhängigen Ansprüche.

Erfindungsgemäß ist vorgesehen, ein Halbleiterbauelement mit mindestens einem Halbleiterkörper und einem Gehäusegrundkörper zu bilden, wobei der Gehäusegrundkörper zur Montage des Halbleiterbauelements eine Auflagefläche aufweist, auf der durch Oberflächenmetallisierung eine Mehrzahl von Lötanschlüssen ausgebildet ist, die zu mehreren Lötanschlußreihen zusammengefaßt sind. Der Abstand der Lötanschlußreihen ist dabei möglichst gering gehalten.

Unter einem möglichst geringen Abstand ist ein Abstand in einem Bereich zu verstehen, dessen untere Grenze durch die erforderliche Isolation zwischen den einzelnen Anschlüssen und der Handhabbarkeit des Bauelements, speziell beim Einlötprozeß, vorgegeben ist. Insbesondere ist der Abstand so groß zu wählen, daß innerhalb der für das Bauelement vorgesehenen Spezifikation kein Kurzschluß zwischen den Anschlüssen auftritt.

Eine weitere Maßgabe für den möglichst geringen Abstand zwischen den Lötanschlußreihen stellen die üblicherweise in der Halbleiterindustrie verwendeten Anschlußrastermaße dar. Notwendig ist ein Abstand zwischen den Anschlußreihen, der etwa dem Abstand zwischen zwei benachbarten Lötanschlüssen entlang einer Lötanschlußreihe entspricht.

Die Obergrenze des genannten Abstandsbereichs ist einerseits durch die Differenz der thermischen Ausdehnungskoeffizienten von Gehäuse- und Leiterplattenmaterial und andererseits durch den für das Bauelement vorgesehenen Temperaturbereich bestimmt. Diese Grenze kann für die jeweils verwendeten Materialien durch einfache Temperaturwechselprüfungen ermittelt werden. Daraus ergibt sich, wie gering der Abstand zwischen den Lötanschlußreihen zu wählen ist, damit innerhalb des für das Bauelement spezifizierten Temperaturbereichs keine auf thermischer Ausdehnung beruhenden Schäden an der Oberflächenmetallisierung oder den Lötanschlüssen auftreten. Solche Schäden entstehen insbesondere bei einem über die Lötanschlüsse auf einer Leiterplatte befestigten Bauelement als Folge mechanischer Verspannungen zwischen Gehäusegrundkörper und Leiterplatte, wobei die Verspannungen wiederum auf unterschiedlicher thermischer Ausdehnung von Leiterplatte und Gehäusegrundkörper beruhen.

Bei der Erfindung wird somit vorteilhafterweise die Gefahr von Schäden an der Oberflächenmetallisierung, den Lötanschlüssen oder im eingelöteten Zustand an den Lötverbindungen wie beispielsweise einer Ablösung der Oberflächenmetallierung oder der Bruch von Lötverbindungen reduziert. Weiterhin kann mit der Erfindung der für das Bauelement vorgesehene Temperaturbereich erweitert werden.

Ein weiterer Vorteil der Erfindung besteht darin, daß durch die dichte Anordnung der Lötschlüsse das Anschlußraster unabhängig von der Gehäusegröße ist.

Eine besonders bevorzugte Ausführungsform der Erfindung besteht darin, die Lötanschlußreihen parallel anzuordnen, da dies eine besonders dichte Anordnung der einzelnen Lötschlüsse erlaubt. Auch ist diese Anordnung vorteilhaft bei Verwendung automatischer Bestückungsanlagen.

Weiterhin ist es hinsichtlich der mechanischen Stabilität der eingelöteten Bauelemente vorteilhaft, die beiden Leiterbahnen symmetrisch zu einer Symmetrieachse des Gehäuses anzuordnen.

Bei der Erfindung sind die Lötanschlüsse in Ausnehmungen des Gehäuses angeordnet. Durch die so entstehenden Stege zwischen den Lötanschlüssen wird vorteilhafterweise der Abstand zwischen Lötanschluß und Leiterplattenoberfläche genau festgelegt.
Weiterhin wird so die Isolation zwischen den einzelnen Lötanschlüssen erhöht und die Ausbildung von fehlerhaften Lötbrükken verhindert.

Bei einer besonders bevorzugten Ausführungsform wird als Gehäuseformmasse PPA (Polyphthalamid) verwendet. Dadurch ist eine sehr kostengünstige Herstellung des Bauelements möglich. Weiterhin kann PPA mit Vorteil leicht von automatischen Herstellungsmaschinen geformt und verarbeitet werden. Die Erfindung erlaubt die Verwendung von PPA, da die nachteiligen Effekte, die durch verschiedene thermische Ausdehnungskoeffizienten des PPA-Bauelementgehäuses bzw. der Leiterplatte hervorgerufen werden, vorteilhaft reduziert sind. Bei Bauelementen nach dem Stand der Technik hingegen müssen spezielle Gehäusematerialien mit thermischen Ausdehnungskoeffizienten, die an das Leiterplattenmaterial angepaßt sind, eingesetzt werden. Solche Materialien wie beispielsweise LCP (Liquid Crystal Polymer) sind deutlich teurer als PPA und schwieriger zu verarbeiten.

Eine bevorzugte Weiterbildung der Erfindung besteht in Gehäuseformen mit zwei in geringem Abstand voneinander angeordneten Lötanschlußreihen mit jeweils der gleichen Anzahl von Lötanschlüssen. Diese Anordnung vereinfacht besonders die zur elektrischen Verbindung der Lötanschlüsse mit dem Halbleiterkörper erforderliche Leiterbahnstruktur.

Hinsichtlich der Beständigkeit gegen thermische Wechselbeanspruchung erlaubt die Erfindung dabei eine deutlich größere Anzahl von Kontaktanschlüssen als Bauelemente nach dem Stand der Technik.

Weitere Merkmale, Vorzüge und Zweckmäßigkeiten der Erfindung ergeben sich aus der nachfolgenden Beschreibung von einen Ausführungsbeispiel in Verbindung mit den Figuren 1 bis 3. Gleiche Elemente sind mit gleichen Bezugszeichen versehen.
Es zeigen:
- Figur 1: ein schematische Darstellung eines Bauelements das nicht Teil der Erfindung ist, oben Merkmale davon darstellt,
- Figur 2: eine schematische Darstellung einer Ausführungsform eines erfindungsgemäßen Bauelements und
- Figur 3: eine schematische Darstellung eines Bauelements nach dem Stand der Technik.

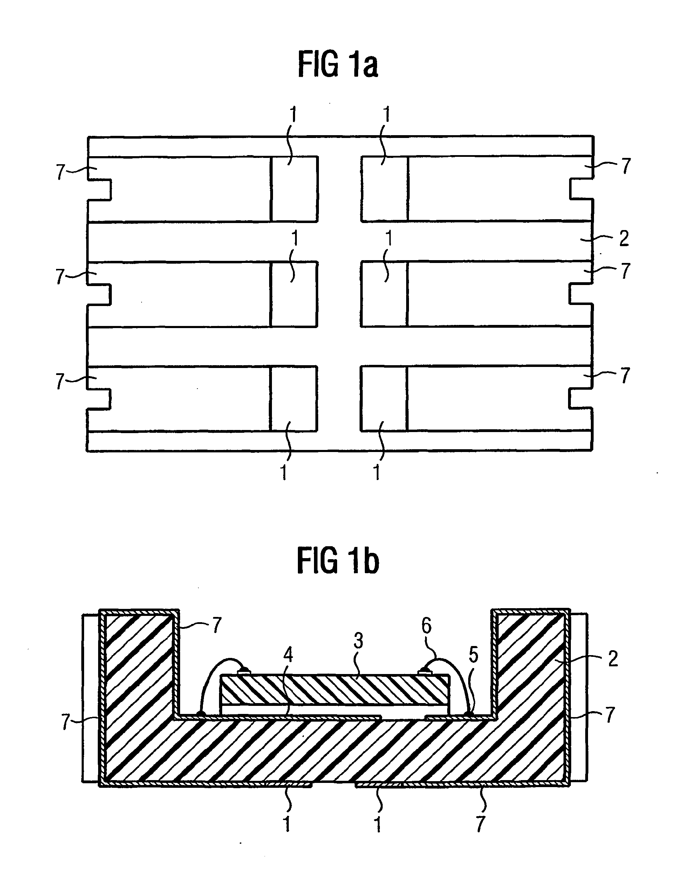

Figur 1b zeigt eine Schnittansicht eines Halbleiterbauelements, das in MID-Technik hergestellt ist. Bei der MID-Technik bzw. der CIMID-Technik wird als Gehäuse ein Grundkörper 2 mit einer Ausnehmung verwendet, in der der Halbleiterkörper 3 angeordnet ist. Auf dem Gehäusegrundkörper 2 sind mittels einer Oberflächenmetallisierung Leiterbahnstrukturen 7 geformt, die im Inneren der Ausnehmung den Chipanschlußbereich 4 und den Drahtanschlußbereich 5 zur Kontaktierung des Halbleiterkörpers 3 bilden. Die elektrische Verbindung zwischen dem Halbleiterkörper 3 und den Leiterbahnstrukturen 7 kann beispielsweise durch Drahtverbindungen 6 hergestellt sein.

Auf der Außenseite des Gehäuses sind durch die Leiterbahnstrukturen 7 Lötanschlüsse 1 ausgebildet. Die elektrische Verbindung zwischen Chipanschlußbereich 4 bzw. Drahtanschlußbereich 5 und den Lötanschlüssen 1 erfolgt ebenfalls durch Leiterbahnen 7, die auf der Oberfläche des Gehäusegrundkörpers 2 verlaufen.

In Figur 1a ist die Aufsicht auf die Seite des Gehäuses gezeigt, auf der die Lötanschlüsse 1 ausgebildet sind. Die insgesamt sechs Lötanschlüsse sind in zwei Reihen zu je drei Anschlüssen angeordnet (die Anzahl stellt selbstverständlich keine Einschränkung der Erfindung dar), wobei die Reihen parallel verlaufen und eng benachbart angeordnet sind. Durch diese dichte Anordnung wird verhindert, daß die thermische Ausdehnung des Gehäusegrundkörpers 2 eine starke Versetzung der Lötanschlüsse 1 mit sich bringt. Als Versetzung ist hierbei die Strecke bezeichnet, um die sich jeweils ein Lötanschluß 1 bei Erwärmung oder Abkühlung innerhalb des betrachteten Temperaturintervalls aufgrund der Expansion des Gehäusegrundkörpers 2 gegenüber der Leiterplatte verschiebt. Das durch die Erfindung bewirkte, günstige thermische Verhalten des Bauelements beruht darauf, daß in linearer Näherung die Größe der Versetzung proportional zum Abstand der Lötanschlüsse ist, so daß eine dichte Anordnung der Lötanschlüsse 1 mit geringem gegenseitigem Abstand auch eine nur geringe Versetzung der Lötanschlüsse 1 zur Folge hat. Eine geringe Versetzung bewirkt im eingelöteten Zustand des Bauelements nur geringe Verspannungen in den Lötstellen und vermindert dadurch die Gefahr eines Bruchs der Lötstelle.

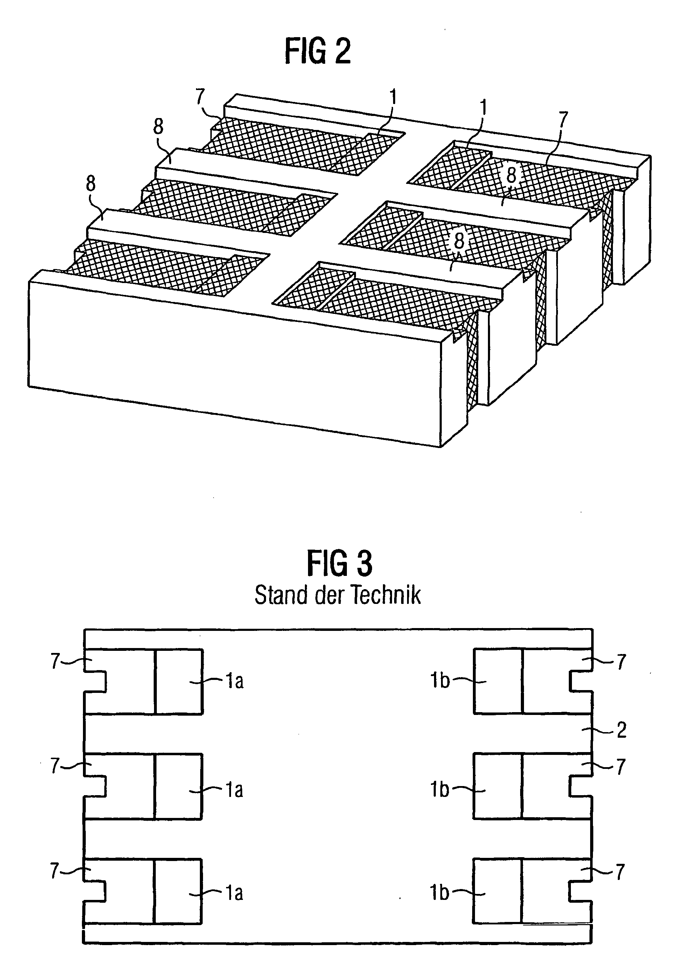

Zum Vergleich ist in Figur 3 eine Lötstellenanordnung nach dem Stand der Technik gezeigt. Hierbei sind die Lötanschlüsse 1a, 1b in zwei Reihen entlang und in der Nähe der Gehäusekanten angeordnet. Die jeweils gegenüberliegenden Lötanschlüsse 1a und 1b sind damit weit voneinander entfernt. Dies führt zu den oben beschriebenen großen Versetzungen bei thermischer Expansion sowie gegen Temperaturwechselbeanspruchung unbeständigen Lötstellen.

In Figur 2 ist perspektivisch ein Ausführungsbeispiel der Erfindung gezeigt. Hier sind die Leiterbahnen 7 und die Lötanschlüsse 1 in Ausnehmungen auf der Gehäuseoberfläche angeordnet. Die so gebildeten Stege 8 zwischen den Leiterbahnen liegen im eingebauten Zustand des Bauelements direkt auf der Leiterplatte auf und bestimmen genau und reproduzierbar den Abstand zwischen den Lötanschlüssen 1 und der Leiterplatte. Durch diese Festlegung wird die Qualität der Lötverbindungen zwischen Leiterplatte und Bauelement weiter erhöht.

Weiterhin werden durch die Stege 8 die einzelnen Lötanschlüsse 1 effizient voneinander isoliert. Dies verhindert, daß sich beim Bestückungsprozeß fehlerhafte Lötbrücken zwischen den einzelnen Lötanschlüssen 1 ausbilden.

Als Gehäusematerial können Thermoplaste wie beispielsweise PPA verwendet werden. Diese Materialien haben sich bei der Herstellung von Gehäusen im Spritzgußverfahren bewährt, weichen aber in ihrem thermischen Ausdehnungskoeffizienten stark von dem thermischen Ausdehnungskoeffizienten typischer Leiterplattenmaterialien wie beispielsweise FR4 ab.

Alternative Werkstoffe mit einem thermischen Ausdehnungskoeffizienten, der dem von Leiterplattenmaterialien ähnelt, beispielsweise LCP, sind deutlich teuerer, im Spritzgußverfahren schwieriger zu verarbeiten oder schlechter zu metallisieren als PPA. Vorteilhafterweise sind Thermoplaste wie PPA als Gehäuseformmasse bei erfindungsgemäßen Bauelementen verwendbar.

Die dargestellten Gehäuse in CIMID-Technik eignen sich zum Aufbau größerer, dreidimensionaler Bauelementstrukturen. Einen weiteren Anwendungsbereich dieser Gehäuse stellen optische Bauelemente wie z.B. Leuchtdioden, Photodioden oder Reflexlichtschranken dar, bei denen die Ausnehmung über dem Halbleiterkörper durch geeignete, strahlungsdurchlässige Materialien abgedeckt wird. Selbstverständlich ist die Erfindung nicht auf diese oder die oben beschriebenen Ausführungsbeispiele beschränkt, sondern stellt vielmehr ein Anschlußdesign für Bauelemente mit Oberflächenmetallisierung dar, das die thermische Belastbarkeit der Bauelemente im eingebauten Zustand erhöht.

## Patentansprüche

1. Halbleiterbauelement mit mindestens einem Halbleiterkörper (3) und einem Gehäusegrundkörper (2), der zur Montage des Halbleiterbauelements eine Auflagefläche an einer Außenseite aufweist, auf der durch Oberflächenmetallisierung eine Mehrzahl von Lötanschlüssen (1) ausgebildet ist, wobei die Lötanschlüsse (1) zu mehreren Lötanschlußreihen zusammengefasst sind,
**dadurch gekennzeichnet,**
**dass** der Abstand zwischen den Lötanschlussreihen dem Abstand zwischen zwei benachbarten Lötanschlüssen entlang einer Lötanschlussreihe entspricht, dass auf dem Gehäusegrundkörper (2) mittels der Oberflächenmetallisierung Leiterbahnstrukturen (7) geformt sind, dass durch die Leiterbahnstrukturen (7) die Lötanschlüsse (1) ausgebildet sind und dass die Leiterbahnen (7) und die Lötanschlüsse (1) in Ausnehmungen auf der Gehäuseoberfläche angeordnet sind, so dass Stege (8) zwischen den Leiterbahnen gebildet sind.

2. Halbleiterbauelement nach Anspruch 1, **dadurch gekennzeichnet, daß** die Lötanschlußreihen parallel angeordnet sind.

3. Halbleiterbauelement nach Anspruch 1 oder 2, **dadurch gekennzeichnet, daß** die Lötanschlußreihen symmetrisch zu einer Symmetrieachse des Gehäuses angeordnet sind.

4. Halbleiterbauelement nach einem der Ansprüche 1 bis 3, **dadurch gekennzeichnet, daß** der Gehäusegrundkörper aus einer Formmasse gebildet ist.

5. Halbleiterbauelement nach Anspruch 4, **dadurch gekennzeichnet, daß** die Formmasse Polyphthalamid enthält.

6. Halbleiterbauelement nach einem der Ansprüche 1 bis 5, **dadurch gekennzeichnet, daß** auf der Auflagefläche zwei Lötanschlußreihen mit der gleichen Anzahl von Lötanschlüssen (1) ausgebildet sind.

7. Verwendung eines Halbleiterbauelements nach einem der Ansprüche 1 bis 6 zur Herstellung von Leuchtdioden, Photodioden und Reflexlichtschranken.

## Claims

1. Semiconductor component comprising at least one semiconductor body (3) and a housing main body (2), which has, for the mounting of the semiconductor component, a bearing area at an outer side, on which a plurality of soldering connections (1) are formed by surface metallization, wherein the soldering connections (1) are combined to form a plurality of soldering connection rows,
**characterized**
**in that** the distance between the soldering connection rows corresponds to the distance between two adjacent soldering connections along a soldering connection row, in that conductor track structures (7) are formed on the housing main body (2) by means of the surface metallization, in that the soldering connections (1) are formed by the conductor track structures (7), and in that the conductor tracks (7) and the soldering connections (1) are arranged in recesses on the housing surface, such that webs (8) are formed between the conductor tracks.

2. Semiconductor component according to Claim 1,
**characterized in that**
the soldering connection rows are arranged in parallel.

3. Semiconductor component according to Claim 1 or 2,
**characterized in that**
the soldering connection rows are arranged symmetrically with respect to an axis of symmetry of the housing.

4. Semiconductor component according to any of Claims 1 to 3,
**characterized in that**
the housing main body is formed from a moulding compound.

5. Semiconductor component according to Claim 4,
**characterized in that**
the moulding compound contains polyphthalamide.

6. Semiconductor component according to any of Claims 1 to 5,
**characterized in that**
two soldering connection rows having the same number of soldering connections (1) are formed on the bearing area.

7. Use of a semiconductor component according to any of Claims 1 to 6 for producing light-emitting diodes, photodiodes and reflected light barriers.

## Revendications

1. Elément à semi-conducteur comportant au moins un corps à semi-conducteur (3) et un corps de base de boîtier (2), qui présente pour le montage de l'élément à semi-conducteur une face de dépôt sur un côté extérieur, sur laquelle une multiplicité de raccords à braser (1) sont formés par métallisation de surface, dans lequel les raccords à braser (1) sont rassemblés en plusieurs rangées de raccords à braser, **caractérisé en ce que** la distance entre les rangées de raccords à braser correspond à la distance entre deux raccords à braser voisins le long d'une rangée de raccords à braser, **en ce que** des structures de pistes conductrices (7) sont formées sur le corps de base de boîtier (2) au moyen de la métallisation de surface, **en ce que** les raccords à braser (1) sont formés par les structures de pistes conductrices (7) et **en ce que** les pistes conductrices (7) et les raccords à braser (1) sont disposés dans des évidements sur la surface du boîtier, de telle manière que des nervures (8) soient formées entre les pistes conductrices.

2. Elément à semi-conducteur selon la revendication 1, **caractérisé en ce que** les rangées de raccords à braser sont disposées de façon parallèle.

3. Elément à semi-conducteur selon la revendication 1 ou 2, **caractérisé en ce que** les rangées de raccords à braser sont disposés de façon symétrique par rapport à un axe de symétrie du boîtier.

4. Elément à semi-conducteur selon l'une quelconque des revendications 1 à 3, **caractérisé en ce que** le corps de base du boîtier est formé en une masse de moulage.

5. Elément à semi-conducteur selon la revendication 4, **caractérisé en ce que** la masse de moulage contient du polyphtalamide.

6. Elément à semi-conducteur selon l'une quelconque des revendications 1 à 5, **caractérisé en ce que** deux rangées de raccords à braser comportant le même nombre de raccords à braser (1) sont formées sur la face de dépôt.

7. Utilisation d'un élément à semi-conducteur selon l'une quelconque des revendications 1 à 6 pour la fabrication de diodes électroluminescentes, de photodiodes et de barrières lumineuses à réflexion.
